(19) Europäisches Patentamt / European Patent Office / Office européen des brevets

(11) **EP 3 657 180 B1**

(12) **FASCICULE DE BREVET EUROPEEN**

(45) Date de publication et mention
de la délivrance du brevet:
**22.02.2023 Bulletin 2023/08**

(21) Numéro de dépôt: **19208746.8**

(22) Date de dépôt: **12.11.2019**

(51) Classification Internationale des Brevets (IPC):
***G01R 15/20*** *(2006.01)*

(52) Classification Coopérative des Brevets (CPC):
**G01R 15/207**

(54) **NOYAU MAGNETIQUE POUR CAPTEUR DE MESURE DE COURANT**

MAGNETISCHER KERN FÜR STROMSENSOR

MAGNETIC CORE FOR CURRENT SENSOR

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **22.11.2018 FR 1871700**

(43) Date de publication de la demande:
**27.05.2020 Bulletin 2020/22**

(73) Titulaire: **Valeo eAutomotive France SAS
95800 Cergy (FR)**

(72) Inventeur: **KOLLI, Abdelfatah
51100 Reims (FR)**

(74) Mandataire: **Argyma
14 Boulevard de Strasbourg
31000 Toulouse (FR)**

(56) Documents cités:
**WO-A1-2010/149331     WO-A1-2013/161496
CN-Y- 201 277 993     JP-A- 2006 066 718
US-A1- 2006 290 454**

**Description**

## DOMAINE TECHNIQUE ET OBJET DE L'INVENTION

La présente invention concerne un noyau magnétique pour capteur de mesure de courant et plus particulièrement un noyau magnétique monté dans un équipement électrique d'un véhicule automobile, notamment électrique ou hybride, afin de concentrer le champ magnétique au niveau de l'élément sensible d'un capteur de mesure d'un courant dans ledit équipement électrique. L'invention vise notamment à améliorer les performances d'un tel noyau magnétique.

## ETAT DE LA TECHNIQUE

Comme cela est connu, un véhicule automobile électrique ou hybride comprend un système de motorisation électrique alimenté par une batterie d'alimentation haute tension via un réseau électrique embarqué haute tension et une pluralité d'équipements électriques auxiliaires alimentés par une batterie d'alimentation basse tension via un réseau électrique embarqué basse tension.

La batterie d'alimentation haute tension assure une fonction d'alimentation en énergie du système de motorisation électrique permettant la propulsion du véhicule. Plus précisément, afin de commander la machine électrique entrainant les roues du véhicule ou de stocker de l'énergie fournie par la machine électrique dans la batterie d'alimentation haute tension, il est connu d'utiliser un onduleur permettant de convertir le courant continu fourni par la batterie d'alimentation haute tension en un ou plusieurs courants de commande alternatifs, par exemple sinusoïdaux ou de convertir un ou plusieurs courants de commande alternatifs fournis par la machine électrique en un courant continu dont l'énergie électrique peut alors être stockée par la batterie d'alimentation haute tension.

Dans une solution connue, l'onduleur se présente sous la forme d'un boitier dans lequel sont montés des composants électroniques de puissance par lesquels passe l'énergie alimentant la machine électrique ou l'énergie reçue de la machine électrique. Ces composants électroniques de puissance sont contrôlés par un pilote (« driver » en langue anglaise) qui est lui-même contrôlé par une unité électronique de contrôle. Dans le cas d'un moteur triphasé, l'onduleur comprend trois conducteurs électriques, dits « conducteurs de phase », permettant de commander le moteur en utilisant trois courants dits « de phase » déphasés deux à deux, par exemple de 120°. Ces courants de phase sont générés par l'onduleur à partir du courant délivré par la batterie haute tension. Pour ce faire, l'onduleur comprend un premier conducteur de batterie, dit « conducteur positif », adapté pour être relié à un potentiel positif de la batterie, et un deuxième conducteur de batterie, dit « conducteur négatif », adapté pour être relié à un potentiel négatif de la batterie d'alimentation haute tension.

L'unité électronique de contrôle commande le pilote afin qu'il contrôle les composants électroniques de puissance pour qu'ils réalisent la conversion du courant continu en courants de phase alternatifs ou vice-versa. A cette fin, l'unité électronique de contrôle se présente sous la forme d'une carte électronique sur laquelle sont montés des composants électroniques reliés par des pistes électriques et permettant de commander le pilote. De même, le pilote se présente sous la forme d'une carte électronique sur laquelle sont montés des composants électroniques reliés par des pistes électriques et permettant de commander les composants électroniques.

Afin de contrôler le fonctionnement de l'onduleur, il peut être nécessaire de détecter les variations de l'intensité des courants de phase circulant dans chaque conducteur de phase. A cette fin, il est connu d'utiliser pour chaque conducteur de phase un capteur, dit « à effet Hall », relié à l'unité de contrôle électronique et comportant un élément sensible magnétiquement s'étendant à proximité du conducteur de phase. Ainsi, lorsqu'un courant circule dans le conducteur de phase, il émet un champ magnétique que l'élément sensible du capteur mesure afin d'en déduire la valeur de l'intensité dudit courant ou les variations d'intensité dudit courant.

Afin d'améliorer la précision de la mesure, il est connu de canaliser le champ magnétique généré par la circulation du courant dans le conducteur de phase en utilisant un noyau magnétique.

Les documents CN201 277 993 Y, WO 2010/149331 A1, JP 2006 066718 A, WO 2013/161496 A1 et US 2006/290454 A1 montrent des capteurs de courant ayant des noyaux magnétiques présentant une section longitudinale de forme elliptique.

Dans les solutions existantes, un tel noyau magnétique est constitué d'une pièce ferromagnétique en forme de U ou de C délimitant un entrefer dans lequel est inséré l'élément sensible du capteur de mesure. Or, de tels noyaux magnétiques présentent un volume intérieur important qui entraine une plage de linéarité faible de sorte que les mesures saturent rapidement lorsque le courant varie de manière importante. En outre, la saturation entraine des effets de couplage (encore appelés diaphonie) sur les noyaux magnétiques des capteurs voisins détériorant ainsi la qualité des mesures, ce qui présentent des inconvénients importants.

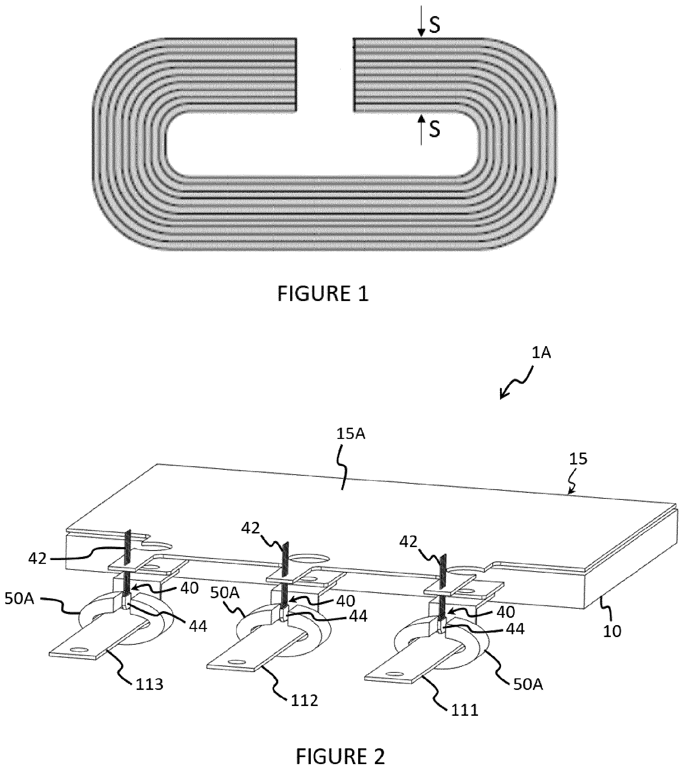

Afin de pallier en partie ces problèmes, une solution connue consiste à utiliser un noyau magnétique de section rectangulaire avec des coins arrondis (voir figure 1) constitué de bandes ferromagnétiques laminées de faible épaisseur, de l'ordre de 0,2 mm chacune, et présentant un faible volume intérieur de manière à entourer au plus près le conducteur de phase. Un tel noyau magnétique présente une plage de linéarité importante et un couplage limité avec les noyaux des capteurs avoisinants.

Typiquement, un noyau magnétique peut être caractérisé par sa reluctance comme suit :

[Math. 1]

$$\Re_C = \frac{L_C}{\mu_0 \mu_r S}$$

où

[Math. 2] $\Re_C$ est la reluctance du noyau magnétique, $\mu 0$ est la perméabilité du vide, qui est une constante, $\mu r$ est la perméabilité relative du ferromagnétique du noyau, Le est la longueur moyenne effective du champ magnétique dans le noyau. Cette longueur moyenne est définie comme le chemin situé à équidistance entre les bords internes et externes du noyau. S est la section transversale du noyau magnétique, qui correspond notamment à la section orthogonale au flux magnétique traversant le noyau magnétique.

Toutefois, ce noyau ne présente pas une plage de linéarité et/ou un encombrement suffisants pour des applications telles que dans un équipement électrique pour un véhicule, par exemple un onduleur ou un convertisseur DCDC ou un chargeur embarqué.

Il existe donc le besoin d'une solution de noyau magnétique présentant une plage de linéarité et/ou un encombrement amélioré.

## PRESENTATION GENERALE DE L'INVENTION

A cet effet, l'invention a tout d'abord pour objet un ensemble de connexion électrique comme défini par la revendication 1.

Par les termes « section longitudinale de forme elliptique », on entend que la section longitudinale du dispositif, lorsque la ou les pièces métalliques sont positionnées pour être utilisées avec un capteur de mesure de courant, est de forme elliptique au moins sur sa section interne.

L'utilisation d'une section longitudinale de forme elliptique permet de réduire la longueur moyenne effective du noyau magnétique par rapport à l'art antérieur, ce qui permet de réduire la reluctance du dispositif par rapport à l'art antérieur. Le noyau magnétique présente ainsi une reluctance plus faible donc une plage de linéarité plus importante par rapport à l'art antérieur à matériau et section identiques. Alternativement, le noyau magnétique présente un espace (ou volume) intérieur plus restreint par rapport à l'art antérieur à reluctance identique et plage de linéarité identique. L'utilisation d'une section longitudinale de forme elliptique permet ainsi également d'ajuster l'espace intérieur délimité par la ou les portions concaves de la ou des pièces ferromagnétiques afin d'entourer au plus près la lame du conducteur électrique.

Dans une forme de réalisation, le noyau magnétique comprend une unique pièce ferromagnétique délimitant un unique entrefer, rendant le noyau magnétique monobloc, ce qui permet notamment d'obtenir une précision importante des mesures réalisées par le capteur.

Dans une autre forme de réalisation, le noyau magnétique comprend deux pièces ferromagnétiques en vis-à-vis délimitant deux entrefers, ce qui permet notamment au capteur de mesure de travailler sur un intervalle de linéarité de largeur importante.

De préférence, la longueur moyenne effective du noyau magnétique est inférieure à 50 mm afin d'en réduire la reluctance.

De préférence encore, la reluctance du noyau magnétique est inférieure à 80000 Sturgeon (Henry-1), par exemple à 79577 Sturgeon dans le cas d'un matériau fer-silicium de perméabilité relative $\mu_r$ = 20000.

De manière préférée, le matériau ferromagnétique constituant l'au moins une pièce est un ferroalliage, de préférence un alliage de fer et de silicium (ferrosilicium ou siliciure de fer). L'alliage de fer et de silicium est un matériau de haute induction de saturation (allant jusqu'à 2 T), ce qui permet de maintenir une plage de linéarité accrue. Un autre avantage d'un tel alliage est son faible coût.

Dans une forme de réalisation, le ferroalliage est laminé afin de réduire l'hystérésis du matériau et par conséquent les pertes dans le matériau tout en améliorant la précision de la mesure du courant.

Avantageusement, la largeur de l'entrefer est comprise entre 3 et 8 mm, de préférence entre 3,5 et 5 mm. Ceci permet de réduire les fuites de flux magnétiques, et par conséquent la diaphonie (effets de couplage) avec les éléments environnants.

Avantageusement encore, l'épaisseur de la pièce est comprise entre 3 et 12 mm, de préférence de l'ordre de 5 mm. Une telle épaisseur peut être un bon compromis entre l'espace intérieur du noyau magnétique et la plage de courant à mesurer (linéarité).

Dans une forme de réalisation, l'ensemble de connexion électrique comprend une pluralité de conducteurs électriques et une pluralité de noyaux magnétiques, chaque conducteur électrique s'étendant dans l'espace intérieur d'un noyau magnétique respectif.

Avantageusement, l'ensemble de connexion électrique comprend un surmoulage maintenant ensemble les noyaux magnétiques.

Le bord interne correspond à la partie de l'ellipse qui définit l'espace intérieur du noyau magnétique. Le gabarit correspond à l'encombrement extérieur du conducteur électrique dans l'espace intérieur définit par le noyau magnétique. La distance minimale d3 peut être positive ou nulle.

Dans une forme de réalisation, le conducteur électrique a une section parallélépipédique et est centré sur le centre de l'ellipse et dans lequel le demi grand axe a et le demi petit axe b de l'ellipse sont tels que

[Math. 3]

$$a \geq \frac{f1}{2} + d1$$

**[0030]** , où f1 est la largeur du conducteur électrique suivant la direction du grand axe a, d1 est une première marge entre la périphérie du conducteur électrique et le bord interne du noyau magnétique suivant le grand axe a. Le petit axe b est tel que la distance minimale entre la périphérie du conducteur électrique et le bord interne du noyau magnétique, suivant une direction parallèle au petit axe b, est supérieure ou égale à d2, d2 étant une deuxième marge entre la périphérie du conducteur électrique et le bord interne du noyau magnétique.

De préférence, on a :

[Math. 4]

$$a = \frac{f1}{2} + d1$$

et b est tel que la distance minimale ente le gabarit et le bord interne du noyau magnétique suivant une direction parallèle au petit axe b est égale à d2.

De préférence encore, on a : 1 mm < d1 < 5 mm et/ou 0,5 mm < d2 < 5 mm et/ou 0,5 mm < d3 < 5 mm. La distance d3 et les distances d1 et d2 permettent d'assurer une isolation électrique entre le conducteur électrique et le noyau magnétique.

L'invention concerne également un ensemble de capteur comprenant un ensemble de connexion électrique tel que présenté précédemment et un capteur de mesure comprenant un élément sensible s'étendant dans l'au moins un entrefer de l'au moins un noyau magnétique, ledit élément sensible étant configuré de manière à mesurer une intensité du champ magnétique induit par un courant circulant dans l'au moins un conducteur électrique correspondant.

De manière avantageuse, l'ensemble de capteur comprend en outre une carte électronique comportant un circuit de connexion électrique, le capteur de mesure étant relié électriquement audit circuit de connexion électrique. Une telle carte électronique peut par exemple être un pilote d'un module électronique de puissance ou de composants électroniques de puissance ou bien une unité électronique de contrôle d'un équipement électrique, tel qu'un onduleur ou un convertisseur de tension.

L'invention concerne aussi un équipement électrique, notamment pour véhicule automobile, comprenant un ensemble de connexion électrique tel que présenté ci-avant.

Un tel équipement électrique peut par exemple être un onduleur ou un convertisseur de tension.

L'invention concerne aussi un véhicule électrique ou hybride comprenant une machine électrique, par exemple une machine de motorisation, alimentée par une batterie d'alimentation haute tension via un réseau électrique embarqué haute tension et un équipement électrique, par exemple un onduleur, tel que présenté précédemment, connecté à ladite machine électrique.

## PRESENTATION DES FIGURES

L'invention sera mieux comprise à la lecture de la description qui va suivre, donnée uniquement à titre d'exemple, et se référant aux dessins annexés donnés à titre d'exemples non limitatifs, dans lesquels des références identiques sont données à des objets semblables et sur lesquels :

la figure 1 présente l'art antérieur,

la figure 2 est une vue partielle en perspective d'une première forme de réalisation d'un ensemble selon l'invention,

la figure 3 est une vue en perspective d'une première forme de réalisation du noyau magnétique selon l'invention,

la figure 4 est une vue de côté du noyau magnétique de la figure 3,

la figure 5 est une vue rapprochée de l'un des noyaux magnétiques de l'ensemble de la figure 2,

la figure 6 est une vue de côté d'une variante du noyau magnétique des figures 3 et 4,

la figure 7 est une vue en perspective du noyau magnétique de la figure 6,

la figure 8 est une vue partielle en perspective d'une deuxième forme de réalisation de l'ensemble selon l'invention,

la figure 9 est une vue en perspective d'une deuxième forme de réalisation du noyau magnétique selon l'invention,

la figure 10 est une vue de côté du noyau magnétique de la figure 9,

la figure 11 est une vue rapprochée de l'un des noyaux magnétiques de l'ensemble de la figure 8,

la figure 12 illustre schématiquement un exemple d'ensemble de connexion électrique selon l'invention dans lequel le conducteur électrique est une lame de section rectangulaire,

la figure 13 illustre schématiquement un exemple d'ensemble de connexion électrique selon l'invention dans lequel le conducteur électrique présente une section de forme irrégulière,

la figure 14 est une vue en perspective d'un surmoulage réalisé autour des noyaux magnétiques de l'ensemble de la figure 2,

la figure 15 est une vue en perspective d'un surmoulage réalisé autour de noyaux magnétiques montés autour de conducteurs électriques constitués chacun d'une lame métallique plane.

Il faut noter que les figures exposent l'invention de manière détaillée pour mettre en oeuvre l'invention, lesdites figures pouvant bien entendu servir à mieux définir l'invention le cas échéant.

## DESCRIPTION DETAILLEE DE L'INVENTION

Dans la description qui sera faite ci-après, l'invention sera décrite dans son application à un véhicule automobile électrique ou hybride sans que cela ne soit limitatif de la portée de la présente invention. Dans l'exemple décrit ci-après, le véhicule comprend notamment une machine électrique, un équipement électrique, une batterie d'alimentation haute tension, un réseau électrique embarqué haute tension, une batterie d'alimentation basse tension, un réseau électrique embarqué basse tension et une pluralité d'équipements auxiliaires. Dans cet exemple, l'équipement électrique est un onduleur, sans toutefois que cela ne limite la portée de la présente invention. On notera ainsi que l'équipement électrique pourrait être par exemple un chargeur ou un convertisseur continu-continu (DCDC) embarqués dans le véhicule. Le réseau électrique embarqué basse tension relie la batterie d'alimentation basse tension et la pluralité d'équipements auxiliaires afin que la batterie d'alimentation basse tension alimente lesdits équipements auxiliaires. Ces éléments auxiliaires sont électriques ou électroniques tels que, par exemple, des calculateurs embarqués, des moteurs de lève-vitres, des systèmes de contrôle, des systèmes multimédia, etc. La batterie d'alimentation basse tension délivre typiquement par exemple une tension continue de l'ordre de 12 V, 24 V ou 48 V. La recharge de la batterie basse tension est réalisée à partir de la batterie haute tension via un convertisseur de tension continue en tension continue, appelé communément convertisseur DCDC. Le réseau électrique embarqué haute tension relie la batterie d'alimentation haute tension et l'onduleur afin que la batterie d'alimentation haute tension assure une fonction d'alimentation en énergie de la machine électrique via l'onduleur. La batterie d'alimentation haute tension délivre typiquement une tension continue comprise entre 100 V et 900 V, de préférence entre 100 V et 500 V. La recharge en énergie électrique de la batterie d'alimentation haute tension est réalisée en la connectant, via le réseau électrique haute tension continue du véhicule, à un réseau électrique externe, par exemple un réseau électrique alternatif domestique. La machine électrique est une machine électrique tournante, de préférence destinée à entrainer les roues du véhicule à partir de l'énergie fournie par la batterie d'alimentation haute-tension.

Plus précisément, la machine électrique est une machine électrique à courant alternatif alimentée par une source de courants polyphasés. Par exemple, la machine électrique peut être un moteur à courant alternatif. Dans l'exemple préféré décrit ci-après, la machine électrique est alimentée par une source de courants triphasés sans que cela ne soit limitatif de la portée de la présente invention. Dans cet exemple, la commande de la machine électrique est réalisée au moyen de l'onduleur. L'onduleur permet de convertir le courant continu fourni par la batterie d'alimentation haute tension en une pluralité de courants alternatifs, par exemple sinusoïdaux, dits « de phase », permettant de commander la machine électrique. A l'inverse, dans un autre mode de fonctionnement, la machine électrique peut également fournir des courants de phase alternatifs à l'onduleur afin que l'onduleur les transforme en un courant continu permettant de charger la batterie d'alimentation haute-tension. Dans l'exemple décrit ci-après, l'onduleur est destiné à être relié à une machine électrique triphasée.

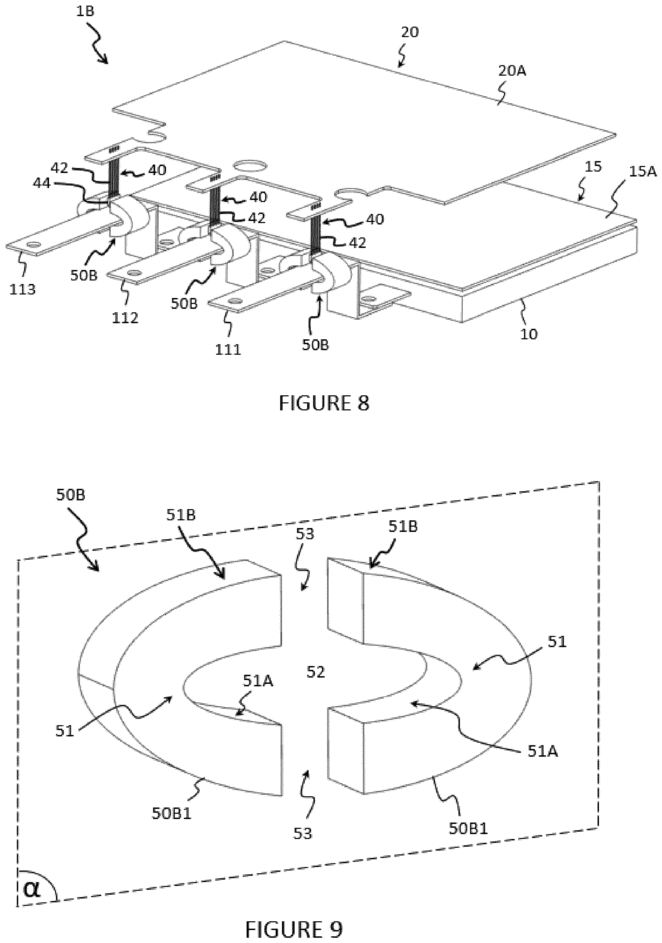

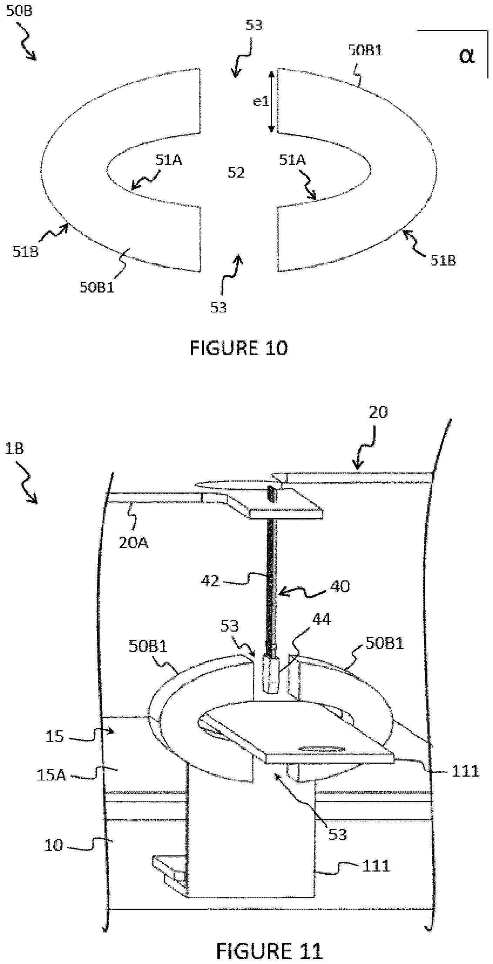

On a représenté sur les figures 2 à 7 une première forme de réalisation d'un ensemble 1A selon l'invention et sur les figures 8 à 11 une deuxième forme de réalisation d'un ensemble 1B selon l'invention. Ces ensembles 1A, 1B, sont notamment compris chacun dans un onduleur.

L'onduleur comprend un boitier dans lequel sont montés, en référence aux figures 2 et 8, un module électronique de puissance 10 comprenant des composants électroniques de puissance (non visibles), un pilote 15 et une unité électronique de contrôle 20 (non représentée sur la figure 2 mais présente). L'ensemble, 1A, 1B comprend en outre des conducteurs électriques 111, 112, 113 de phase, permettant de connecter l'onduleur à la machine électrique.

L'énergie alimentant la machine électrique ou reçue de la machine électrique passent par les composants électroniques de puissance du module électronique de puissance 10, dans cet exemple au nombre de trois, qui sont destinés à transformer le courant continu en courants alternatifs ou vice-versa. Ces composants électroniques de puissance peuvent comprendre des interrupteurs électroniques, tels que par exemple des transistors semi-conducteurs, agencés en circuit électrique pour permettre un passage commandé d'énergie électrique entre la batterie d'alimentation haute tension et la machine électrique. En particulier, les composants électroniques de puissance peuvent être des puces semi-conductrices nues pour lesquels le corps du module électronique de puissance 10, réalise une encapsulation.

Dans les exemples illustrés, le pilote 15 se présente sous la forme d'une carte électronique 15A reliée électriquement aux composants électroniques de puissance du module électronique de puissance 10. Cette carte électronique comporte des composants électroniques (non représentés) reliés entre eux par des pistes conductrices permettant notamment de commander les composants électroniques de puissance, notamment des transistors ou des puces semi-conductrices. La carte électronique 15A peut notamment comporter un premier ensemble de pistes électriques, appelé bus continu, et un deuxième ensemble de pistes électriques, appelé bus alternatif, entre lesquels sont connectés les composants électroniques de puissance. Le bus alternatif est relié aux conducteurs électrique 111, 112, 113 de l'ensemble 1A, 1B. De plus, le pilote 15 peut être configuré pour échanger des signaux de données avec l'unité électronique de contrôle 20.

Dans les exemples illustrés, l'unité électronique de contrôle 20 se présente sous la forme d'une carte électronique 20A sur laquelle sont montés des composants électroniques (non représentés) reliés entre eux par des pistes conductrices et permettant de commander le pilote 15.

Dans les exemples illustrés, non limitatifs, la carte électronique 15A du pilote 15 et la carte électronique 20A de l'unité électronique de contrôle 20 sont montées de manière superposées. Ces cartes électroniques 15A, 20A peuvent être fixées sur une paroi du boitier 5 ou sur un élément de support (non représenté, qui peut par exemple être une plaque) suspendu dans le logement défini par le boitier 5.

Chaque conducteur électrique 111, 112, 113 permet de relier électriquement un composant électronique de puissance du module électronique de puissance 10 à une phase de la machine électrique. A cette fin, chaque conducteur électrique 111, 112, 113 traverse une ouverture du boitier 5 pour permettre de relier l'onduleur 1, 1A, 1B à la machine électrique et notamment permettre la circulation des courants alternatifs entre les composants électroniques de puissance du module électronique de puissance 10 et la machine électrique. Chaque conducteur électrique 111, 112, 113 se présente sous la forme d'une lame métallique, par exemple réalisée en cuivre, en acier, en aluminium ou tout autre matériau conducteur. Cette lame peut être éventuellement repliée une ou plusieurs fois, comme cela est le cas dans l'exemple illustré. Chaque conducteur électrique 111, 112, 113 peut en outre avantageusement être recouvert d'une surface anti-usure, par exemple composée d'étain et de nickel.

Afin de mesurer l'intensité du courant circulant dans chaque conducteur électrique 111, 112, 113, l'ensemble 1A, 1B comprend, pour chaque conducteur électrique 111, 112, 113, un capteur de mesure 40, soit trois capteurs de mesure 40 dans les exemples illustrés. Ces capteurs de mesure 40 peuvent être montés, via une ou plusieurs broches de connexion 42, sur la carte électronique du pilote 15 (comme illustré sur la figure 2) ou bien sur la carte électronique de l'unité électronique de contrôle 20 (comme illustré sur la figure 8). Chaque capteur de mesure 40 comprend un élément sensible 44 disposé en regard d'un conducteur électrique 111, 112, 113 afin de mesurer l'intensité du champ magnétique induit par la circulation d'un courant dans ledit conducteur électrique 111, 112, 113.

L'élément sensible 44 fourni les mesures d'intensité du champ magnétique à la carte électronique 15A, 20A sur laquelle il est monté de sorte que ladite carte électronique 15A, 20A puisse la convertir en une valeur proportionnelle d'intensité de courant ou bien de sorte que la carte électronique 15A, 20A puisse observer les variations d'intensité du champ magnétique qui sont proportionnelles aux variations d'intensité du courant circulant dans le conducteur électrique 111, 112, 113. Les capteurs de mesure 40 sont par exemple des capteurs à effet Hall, connus en soi.

Chaque ensemble 1A, 1B comprend un conducteur électrique 111, 112, 113 et un capteur de mesure 40 et un noyau magnétique 50A, 50B entourant une portion du conducteur électrique 111, 112, 113 au niveau de laquelle l'élément sensible 44 du capteur de mesure 40 est placé.

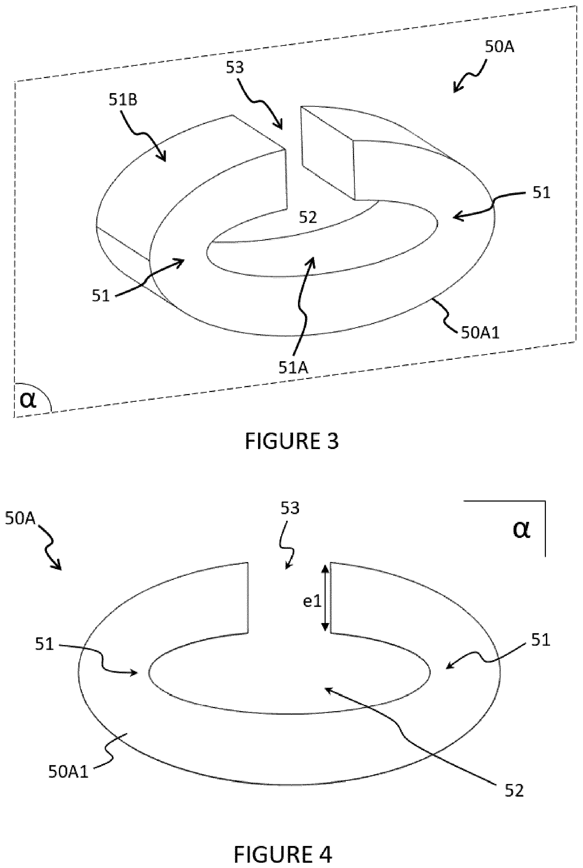

Le noyau magnétique 50A, 50B comprend au moins une pièce 50A1, 50B1 ferromagnétique comportant au moins une portion concave 51 s'étendant selon un plan longitudinal α et délimitant un espace intérieur 52 et au moins un entrefer 53. Le noyau magnétique 50A, 50B présente une section longitudinale de forme elliptique. Par les termes « section elliptique », on entend dans la présente description que la section longitudinale du noyau magnétique 50A, 50B présente un secteur de forme au moins en partie elliptique au niveau de sa surface interne, également appelée bord interne, 51A, quel que soit le nombre pièces 50A1, 50B1 qu'il comporte. Dans la forme de réalisation illustrée sur les figures 3 à 5 et 8 à 11, la section longitudinale du noyau magnétique 50A, 50B est elliptique aussi bien au niveau de sa surface externe 51B que de sa surface interne 51A. De préférence, l'au moins un matériau ferromagnétique est un ferroalliage, de préférence un alliage de fer et de silicium (ferrosilicium ou siliciure de fer), de préférence laminé afin de réduire le cycle d'hystérésis du matériau, donc les pertes, et d'améliorer la précision de la mesure du courant.

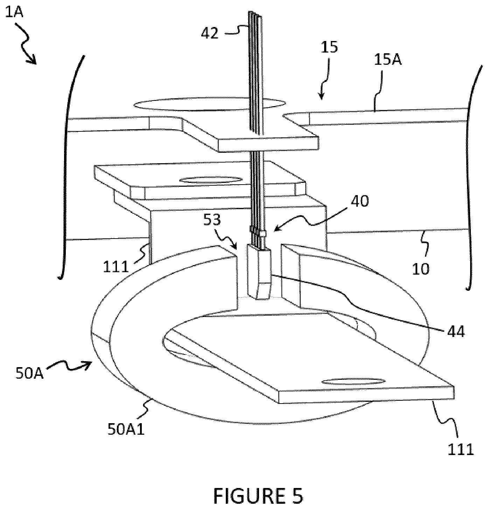

Dans une première forme de réalisation illustrée sur les figures 2 à 7 (ensemble 1A), le noyau magnétique 50A est constitué d'une seule pièce 50A1 monobloc ferromagnétique présentant une section elliptique et délimitant un unique entrefer 53 permettant de recevoir l'élément sensible 44, comme illustré en particulier sur la figure 5. La section elliptique de la pièce 50A1 défini un espace intérieur 52 dans lequel la lame du conducteur électrique 111, 112, 113 s'étend.

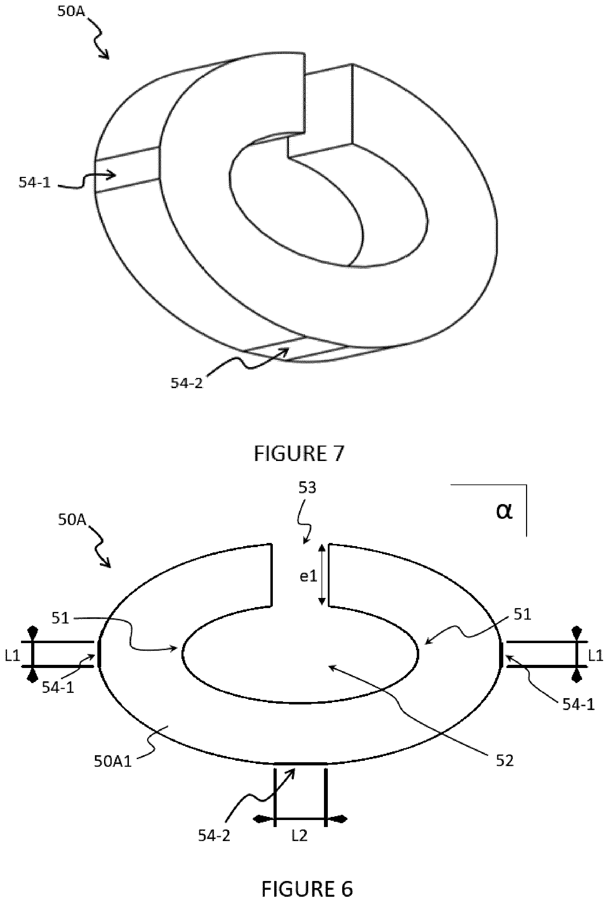

Dans une variante de cette première forme de réalisation, illustrée sur les figures 6 et 7, les extrémités de la pièce 50A sont aplaties. Autrement dit, la pièce 50A présente, au niveau de ses extrémités, des portions 54-1, 54-2 planes afin de permettre un positionnement plus aisé de la pièce 50A lors d'un surmoulage comme cela sera décrit ci-après. De préférence, comme illustré sur la figure 6, la largeur L1 des portions 54-1 planes situées sur le grand rayon de la pièce 50A est inférieure à 8 mm et la largeur L2 de la portion 54-2 plane située sur le petit rayon de la pièce 50A (opposée à l'entrefer 53) est inférieure à 10 mm.

Dans une deuxième forme de réalisation illustrée sur les figures 8 à 11 (ensemble 1B), le noyau magnétique 50B est constitué de deux pièces 50B1 monobloc ferromagnétiques, identiques, dont la section longitudinale présente, lorsqu'elle sont en regard l'une de l'autre, une forme elliptique de sorte que, lorsqu'elles sont positionnées autour de la lame du conducteur électrique 111, 112, 113, la section longitudinale de l'ensemble formé par les deux pièces 50B1 est elliptique et délimite deux entrefers 53, l'élément sensible 44 du capteur de mesure 40 correspondant s'étendant dans l'un des deux entrefers 53. Les deux pièces 50B1 sont symétriques l'une par rapport à l'autre par rapport à un plan médian perpendiculaire au plan longitudinal.

Dans une variante (non représentée) de cette deuxième forme de réalisation, chaque pièce 50B1 pourrait comprendre à son extrémité une portion plane afin de faciliter leur surmoulage.

Dans la première comme dans la deuxième forme de réalisation, la longueur effective de la ou des pièces 50A1, 50B1 (lorsqu'elles sont montées autour d'un conducteur électrique 111, 112, 113) est de préférence inférieure à 50 mm. De même, la largeur de la ou des pièces 50A1, 50B1 est de préférence inférieure à 28 mm et la reluctance du noyau magnétique 50A, 50B est de préférence inférieure à 80000 Sturgeon (Henry$^{-1}$). Dans la première comme dans la deuxième forme de réalisation, la largeur du ou des entrefers est avantageusement comprise entre 3 et 8 mm, de préférence comprise entre 3,5 et 5 mm. Dans la première comme dans la deuxième forme de réalisation, l'épaisseur e1 du secteur elliptique, c'est-à-dire de la ou des pièces 50A1, 50B1, est avantageusement comprise entre 3 et 12 mm, de préférence de l'ordre de 5 mm.

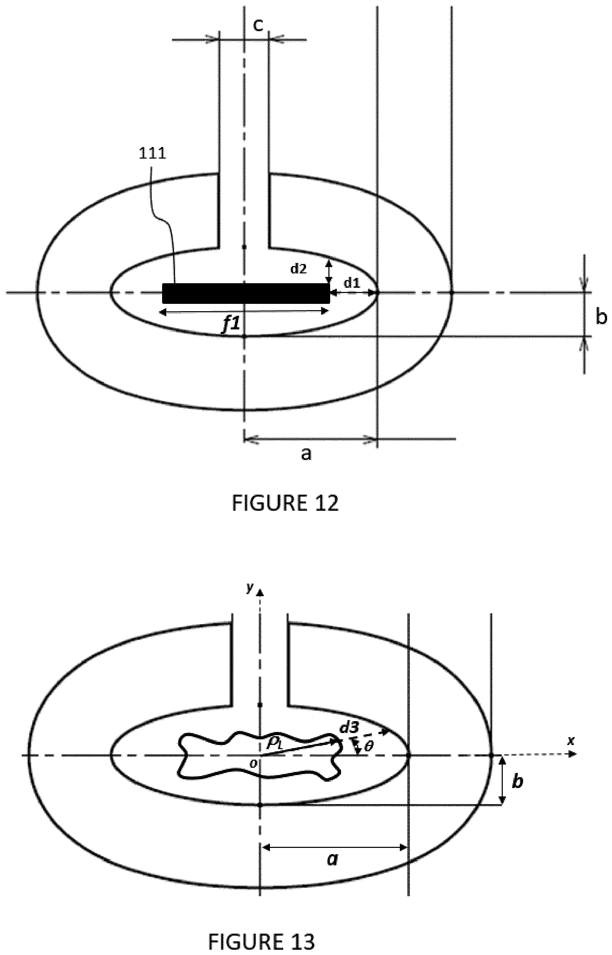

Dans l'exemple de la figure 12, le conducteur électrique 111, 112, 113 a une section parallélépipédique et est centré sur le centre de l'ellipse et dans lequel le demi grand axe a et le demi petit axe b de l'ellipse sont tels que

[Math. 5]

$$a \geq \frac{f1}{2} + d1$$

**[0060]** , où f1 est l'épaisseur du conducteur électrique 111, 112, 113 suivant la direction du grand axe a, d1 est une première marge entre la périphérie du conducteur et le bord interne du noyau magnétique 50A, 50B suivant le grand axe a et b est tel que la distance minimale entre la périphérie du conducteur et le bord interne du noyau magnétique 50A, 50B, suivant une direction parallèle au petit axe b, est supérieure ou égale à d2, d2 étant une deuxième marge entre la périphérie du conducteur électrique 111, 112, 113 et le bord interne du noyau magnétique 50A, 50B.

De préférence,

[Math. 6]

$$a = \frac{f1}{2} + d1$$

et b est tel que la distance minimale entre le gabarit et le bord interne du noyau magnétique 50A, 50B suivant une direction parallèle au petit axe b est égale à d2.

En référence à la figure 13, le bord interne du noyau magnétique 50A, 50B a une section longitudinale en forme d'ellipse, ladite ellipse étant la plus petite ellipse circonscrite au gabarit du conducteur 111, 112, 113 (en particulier de la portion du conducteur 111, 112, 113 comprise dans le volume intérieur) avec une distance minimale d3 entre le gabarit du conducteur électrique 111, 112, 113 et ledit bord interne. Le bord interne correspond à la partie de l'ellipse qui définit le volume intérieur du noyau magnétique 50A, 50B. Le gabarit correspond à l'encombrement extérieur du conducteur électrique 111, 112, 113 dans le volume intérieur défini par le noyau magnétique 50A, 50B. La distance minimale d3 peut être positive ou nulle.

L'ellipse est définie par l'équation :

[Math. 7]

$$\left(\frac{x}{a}\right)^2 + \left(\frac{y}{b}\right)^2 = 1,$$

où a est le demi grand axe et b le demi petit axe, x et y sont les coordonnées le long du repère défini par le demi grand axe a et le demi petit axe b de l'ellipse de centre O.

De préférence, on choisit :

[Math. 8]

$$\frac{a \times b}{\sqrt[2]{b^2 \cos^2(\theta) + a^2 \sin^2(\theta)}} - \rho_L(\theta) \geq d3$$

où

[Math. 9]

$$\theta \in [0, 2\pi]$$

où

[Math. 10]

$\rho_L(\theta)$ est la distance la plus grande de la section longitudinale du conducteur électrique 111, 112, 113 depuis le centre de l'ellipse et

[Math. 11]

$\theta$ est l'angle entre le grand axe de l'ellipse et une droite passant par le centre de l'ellipse. De préférence encore, on a : 1 mm < d1 < 5 mm et/ou 0,5 mm < d2 < 5 mm et/ou 0,5 mm < d3 < 5 mm. La distance d3 et les distances d1 et d2 permettent d'assurer une isolation électrique entre le conducteur électrique et le noyau magnétique 50A, 50B. Par exemple, a = 9 mm et b = 3 mm et c = 3,4 mm (c étant la largeur de l'entrefer 53). La largeur des noyaux magnétiques (largeur de la section longitudinale) peut être comprise entre 4 et 10 mm.

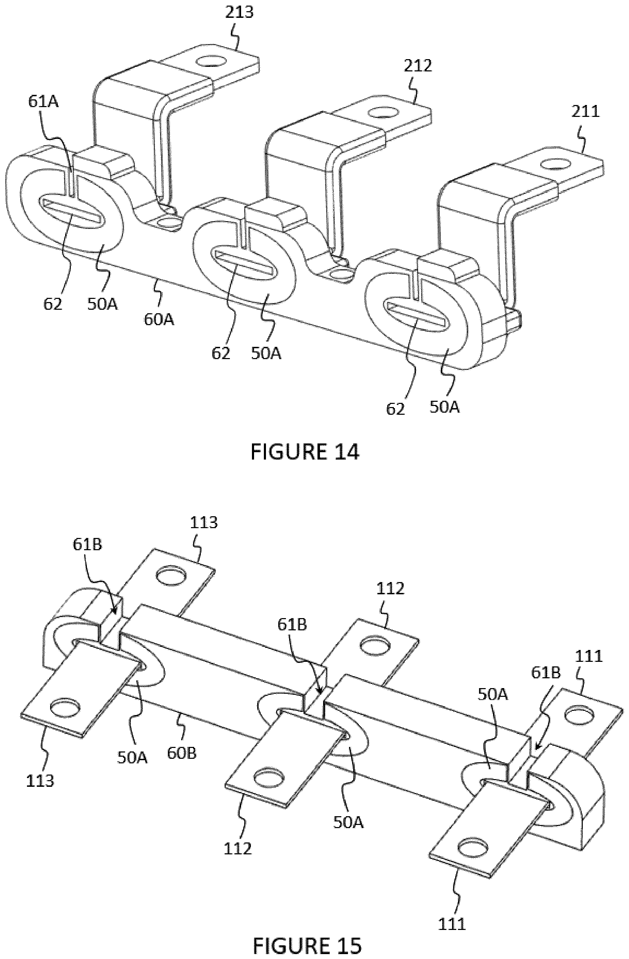

En référence aux figures 14 et 15, de manière avantageuse, l'ensemble 1A, 1B peut comprendre un surmoulage 60A, 60B entourant au moins partiellement les noyaux magnétiques 50A, 50B afin de les maintenir autour des lames des conducteurs électriques 111, 112, 113 lors de leur montage dans l'onduleur.

Ainsi, dans l'exemple illustré sur la figure 14, le surmoulage 60A enveloppe intégralement les noyaux magnétiques 50A. Une lumière 61A, dont la largeur est sensiblement de l'ordre de la moitié de la largeur de l'entrefer 53, est formée dans le surmoulage 60A au niveau de chaque entrefer 53 pour y insérer l'élément sensible 44 du capteur de mesure 40. En outre le surmoulage 60A occupe l'espace intérieur 52 du noyau magnétique 50A, à l'exception d'une fente 62 dans laquelle les conducteurs électriques 111, 112, 113 sont insérés. L'ensemble 1A comprend en outre des seconds conducteurs électriques 211, 212, 213. Après insertion dans la fente 62, les conducteurs 111, 112, 113 viennent se connecter à des seconds conducteurs électriques 211, 212, 213 respectifs.

Dans l'exemple illustré sur la figure 15, le surmoulage 60B enveloppe intégralement les noyaux magnétiques 50A ainsi que les portions de conducteurs électriques 111, 112, 113 situées dans l'espace intérieur 52 desdits noyaux magnétiques 50A. Une lumière 61B, dont la largeur est sensiblement de l'ordre de la largeur de l'entrefer 53, est formée dans le surmoulage 60B au niveau de chaque entrefer 53 pour y insérer l'élément sensible 44 du capteur de mesure 40. Dans cet exemple, les conducteurs électriques 111, 112, 113 peuvent ne pas être surmoulés avec le surmoulage 60B. Ainsi, les conducteurs 111, 112, 113 peuvent être insérés dans des fentes 62 similaires à celles de la figure 14. Dans cet exemple de la figure 15, les conducteurs électriques 111, 112, 113 sont des lames droites (i.e. non pliées).

A grande longueur et grande largeur égales, l'invention permet avantageusement d'améliorer la plage de linéarité du capteur de courant intégrant le noyau magnétique. Ainsi, en comparant le noyau magnétique avec un noyau magnétique de l'art antérieur tel qu'illustré en figure 1, à matériau et section identique on obtient une augmentation de l'ordre de 10 % de la reluctance et une augmentation correspondante de la plage de linéarisation. Par exemple, à grande longueur (25 mm) et grande largeur (10 mm) égales, on obtient une longueur effective de 48,18 mm avec le design selon l'invention contre 52,43 mm avec un design rectangulaire de l'art antérieur, soit un rapport de

[Math. 12]

$$\frac{52,43}{48,18} = 1,09$$

(9 % d'augmentation) qui aussi est égal au rapport des reluctances.

On notera que le noyau magnétique selon l'invention pourrait aussi bien être monté autour des conducteurs électriques de potentiel positif et négatif reliés à une batterie afin de permettre la mesure de l'intensité du champ magnétique induit par la circulation d'un courant dans lesdits conducteurs électriques de potentiel positif et négatif. On notera en outre que les dimensions et les formes des conducteurs électriques 111, 112, 113, et des capteurs de mesure 40 illustrés sur les figures ne sauraient être limitatifs de la portée de la présente invention.

## Revendications

**1.** Ensemble de connexion électrique, comprenant au moins un conducteur électrique (111, 112, 113) et au moins un noyau magnétique (50A, 50B) pour capteur de mesure (40) de courant, dans lequel le conducteur électrique (111, 112, 113) s'étend à travers le noyau magnétique (50A, 50B) de sorte que le noyau magnétique canalise dans son au moins un entrefer des champs magnétiques générés par un courant circulant dans le conducteur électrique (111, 112, 113); le noyau magnétique (50A, 50B) comprenant au moins une pièce (50A1, 50B1) ferromagnétique ; l'au moins une pièce (50A1, 50B1) ferromagnétique comprenant au moins une portion concave (51), s'étendant selon un plan longitudinal (α) et délimitant au moins en partie un entrefer (53) ; ledit entrefer (53) étant apte à recevoir un élément sensible (44) d'un capteur de mesure (40), et la portion concave (51) délimitant un espace intérieur (52), apte à recevoir un conducteur électrique (111, 112, 113) ; le noyau magnétique (50A, 50B) présentant une section longitudinale de forme elliptique, et l'ensemble de connexion électrique étant **caractérisé en ce que** le bord interne (51A) du noyau magnétique (50A, 50B) a une section longitudinale en forme d'ellipse, ladite ellipse étant la plus petite ellipse circonscrite au gabarit du conducteur électrique (111, 112, 113) avec une distance minimale (d3) entre le gabarit du conducteur électrique (111, 112, 113) et ledit bord interne (51A), dans lequel ladite distance minimale (d3) est déterminée en fonction du demi grand axe (a) de ladite ellipse, du demi petit axe (b) de ladite ellipse, de l'angle ($\theta$) entre le grand axe de l'ellipse et une droite passant par le centre de l'ellipse, et de la distance ($\rho_L(\theta)$) la plus grande de la section longitudinale du conducteur électrique (111, 112, 113) depuis le centre de l'ellipse.

**2.** Ensemble de connexion électrique selon la revendication précédente, dans lequel le noyau magnétique présente, au niveau de ses extrémités, des portions planes (54-1, 54-2) afin de permettre un positionnement plus aisé du noyau magnétique (50A) lors d'un surmoulage.

3. Ensemble de connexion électrique selon la revendication 1, dans lequel le noyau magnétique (50A, 50B) comprenant une unique pièce (50A1) ferromagnétique délimitant un unique entrefer (53) ou comprenant deux pièces (50B1) ferromagnétiques en vis-à-vis délimitant deux entrefers (53).

4. Ensemble de connexion électrique selon l'une des revendications 1 à 3, comprenant une pluralité de conducteurs électriques (111, 112, 113) et une pluralité de noyaux magnétiques, chaque conducteur électrique (111, 112, 113) s'étendant dans l'espace intérieur d'un noyau magnétique respectif.

5. Ensemble de connexion électrique selon la revendication précédente, comprenant un surmoulage (60A, 60B) maintenant ensemble les noyaux magnétiques (50A, 50B).

6. Ensemble de connexion électrique selon l'une des revendications 1 à 5, dans lequel le conducteur électrique (111, 112, 113) a une section parallélépipédique et est centré sur le centre de l'ellipse et dans lequel le demi grand axe a et le demi petit axe b de l'ellipse sont tels que

[Math. 13]

$$a \geq \frac{f1}{2} + d1$$

où f1 est l'épaisseur du conducteur électrique (111, 112, 113) suivant la direction du grand axe a et d1 est une première marge entre la périphérie du conducteur électrique (111, 112, 113) et le bord interne du noyau magnétique suivant le grand axe a et b est tel que la distance minimale entre la périphérie du conducteur électrique (111, 112, 113) et le bord interne du noyau magnétique (50A, 50B), suivant une direction parallèle au petit axe b, est supérieure ou égale à d2, d2 étant une deuxième marge entre la périphérie du conducteur électrique (111, 112, 113) et le bord interne (51A) du noyau magnétique (50A, 50B).

7. Ensemble de connexion électrique selon la revendication 6, dans lequel

[Math. 14]

$$a = \frac{f1}{2} + d1$$

et b est tel que la distance minimale ente le gabarit et le bord interne (51A) du noyau magnétique (50A, 50B) suivant une direction parallèle au petit axe B est égale à d2.

8. Ensemble de connexion électrique selon l'une des revendications 6 à 7, dans lequel 1 mm < d1 < 5 mm et/ou 0,5 mm < d2 < 5 mm et/ou, lorsque la revendication 6 dépend de la revendication 7, 0,5 mm < d3 < 5 mm.

9. Ensemble de capteur comprenant un ensemble de connexion électrique selon l'une des revendications 1 à 8 et un capteur de mesure (40) comprenant un élément sensible (44) s'étendant dans l'au moins un entrefer (53) de l'au moins un noyau magnétique (50A, 50B), ledit élément sensible étant configuré de manière à mesurer une intensité du champ magnétique induit par un courant circulant dans l'au moins un conducteur électrique (111, 112, 113) correspondant.

**Patentansprüche**

1. Elektrische Verbindungsanordnung, die mindestens einen elektrischen Leiter (111, 112, 113) und mindestens einen magnetischen Kern (50A, 50B) für einen Stromsensor (40) beinhaltet, wobei sich der elektrische Leiter (111, 112, 113) durch den magnetischen Kern (50A, 50B) erstreckt, sodass der magnetische Kern in seinem mindestens einen Luftspalt Magnetfelder kanalisiert, die durch einen in dem elektrischen Leiter (111, 112, 113) fließenden Strom erzeugt werden; wobei der magnetische Kern (50A, 50B) mindestens ein ferromagnetisches Teil (50A1, 50B1) beinhaltet; wobei das mindestens eine ferromagnetische Teil (50A1, 50B1) mindestens einen konkaven Abschnitt (51) beinhaltet, der sich gemäß einer Längsebene (α) erstreckt und einen Luftspalt (53) mindestens teilweise begrenzt; wobei der Luftspalt (53) dazu fähig ist, ein Sensorelement (44) eines Sensors (40) aufzunehmen, und der konkave Abschnitt (51) einen Innenraum (52) begrenzt, der dazu fähig ist, einen elektrischen Leiter (111, 112, 113) aufzunehmen; wobei der magnetische Kern (50A, 50B) einen ellipsenförmigen Längsschnitt aufweist und wobei die elektrische Verbindungsanordnung **dadurch gekennzeichnet ist, dass** der Innenrand (51A) des magnetischen Kerns (50A, 50B) einen Längsschnitt in Form einer Ellipse aufweist, wobei die Ellipse die kleinste Ellipse ist, die das Profil des elektrischen Leiters (111, 112, 113) mit einem Mindestabstand (d3) zwischen dem Profil des elektrischen Leiters (111, 112, 113) und dem Innenrand (51A) umgibt, wobei der Mindestabstand (d3) in Abhängigkeit von der großen Halbachse (a) der Ellipse, der kleinen Halbachse (b) der Ellipse, dem Winkel ($\theta$) zwischen der großen Achse der Ellipse und einer Geraden, die durch die Mitte der Ellipse verläuft, und dem größten Abstand ($p_L(\theta)$) des Längsschnitts des elektrischen Leiters (111, 112, 113) von der Mitte der Ellipse aus bestimmt wird.

2.  Elektrische Verbindungsanordnung nach dem vorhergehenden Anspruch, wobei der magnetische Kern an seinen Enden ebene Abschnitte (54-1, 54-2) aufweist, um bei einem Umspritzen eine leichtere Positionierung des magnetischen Kerns (50A) zu ermöglichen.

3.  Elektrische Verbindungsanordnung nach Anspruch 1, wobei der magnetische Kern (50A, 50B) ein einziges ferromagnetisches Teil (50A1) beinhaltet, das einen einzigen Luftspalt (53) begrenzt, oder zwei gegenüberliegende ferromagnetische Teile (50B1) beinhaltet, die zwei Luftspalte (53) begrenzen.

4.  Elektrische Verbindungsanordnung nach einem der Ansprüche 1 bis 3, die eine Vielzahl von elektrischen Leitern (111, 112, 113) und eine Vielzahl von magnetischen Kernen beinhaltet, wobei sich jeder elektrische Leiter (111, 112, 113) in dem Innenraum eines jeweiligen magnetischen Kerns erstreckt.

5.  Elektrische Verbindungsanordnung nach dem vorhergehenden Anspruch, die eine Umspritzung (60A, 60B) beinhaltet, die die magnetischen Kerne (50A, 50B) zusammenhält.

6.  Elektrische Verbindungsanordnung nach einem der Ansprüche 1 bis 5, wobei der elektrische Leiter (111, 112, 113) einen parallelepipedischen Querschnitt aufweist und auf die Mitte der Ellipse zentriert ist und wobei die große Halbachse a und die kleine Halbachse b der Ellipse derart sind, dass

[Math. 13]

$$a \geq \frac{f1}{2} + d1$$

wobei f1 die Dicke des elektrischen Leiters (111, 112, 113) gemäß der Richtung der großen Achse a ist und d1 ein erster Spielraum zwischen dem Außenumfang des elektrischen Leiters (111, 112, 113) und dem Innenrand des magnetischen Kerns gemäß der großen Achse a ist und b derart ist, dass der Mindestabstand zwischen dem Außenumfang des elektrischen Leiters (111, 112, 113) und dem Innenrand des magnetischen Kerns (50A, 50B) gemäß einer zu der kleinen Achse b parallelen Richtung größer als oder gleich d2 ist, wobei d2 ein zweiter Spielraum zwischen dem Außenumfang des elektrischen Leiters (111, 112, 113) und dem Innenrand (51A) des magnetischen Kerns (50A, 50B) ist.

7.  Elektrische Verbindungsanordnung nach Anspruch 6, wobei

[Math. 14]

$$a = \frac{f1}{2} + d1$$

und b derart ist, dass der Mindestabstand zwischen dem Profil und dem Innenrand (51A) des magnetischen Kerns (50A, 50B) gemäß einer zu der kleinen Achse B parallelen Richtung gleich d2 ist.

8.  Elektrische Verbindungsanordnung nach einem der Ansprüche 6 bis 7, wobei 1 mm < d1 < 5 mm und/oder 0,5 mm < d2 < 5 mm und/oder, wenn Anspruch 6 von Anspruch 7 abhängt, 0,5 mm < d3 < 5 mm.

9.  Sensoranordnung, die Folgendes beinhaltet: eine elektrische Verbindungsanordnung nach einem der Ansprüche 1 bis 8 und einen Sensor (40), der ein Sensorelement (44) beinhaltet, das sich in dem mindestens einen Luftspalt (53) des mindestens einen magnetischen Kerns (50A, 50B) erstreckt, wobei das Sensorelement so konfiguriert ist, dass es eine Stärke des Magnetfelds misst, das durch einen in dem mindestens einen entsprechenden elektrischen Leiter (111, 112, 113) fließenden Strom induziert wird.

**Claims**

1. Electrical connection assembly, comprising at least one electrical conductor (111, 112, 113) and at least one magnetic core (50A, 50B) for a current measurement sensor (40), in which the electrical conductor (111, 112, 113) extends through the magnetic core (50A, 50B) such that the magnetic core channels, in its at least one air gap, magnetic fields generated by a current circulating in the electrical conductor (111, 112, 113), the magnetic core (50A, 50B) comprising at least one ferromagnetic part (50A1, 50B1), the at least one ferromagnetic part (50A1, 50B1) comprising at least one concave portion (51), extending on a longitudinal plane ($\alpha$) and at least partly delimiting an air gap (53); said air gap (53) being able to receive a sensitive element (44) of a measurement sensor (40), and the concave portion (51) delimiting an internal space (52), able to receive an electrical conductor (111, 112, 113); the magnetic core (50A, 50B) having a longitudinal section of elliptical form, and the electrical connection assembly being **characterized in that** the inner edge (51A) of the magnetic core (50A, 50B) has a longitudinal section of elliptical form, said ellipse being the smallest ellipse circumscribed on the form of the electrical conductor (111, 112, 113) with a minimal distance (d3) between the form of the electrical conductor (111, 112, 113) and said inner edge (51A), wherein said minimal distance (d3) is determined as a function of the half great axis (a) of said ellipse, of the half small axis (b) of said ellipse, of the angle ($\theta$) between the great axis of the ellipse and a straight line passing through the centre of the ellipse, and of the greatest distance ($\rho_L$, ($\theta$)) of the longitudinal section of the electrical conductor (111, 112, 113) from the centre of the ellipse.

2. Electrical connection assembly according to the preceding claim, wherein the magnetic core has, at its ends, flat portions (54-1, 54-2) in order to allow an easier positioning of the magnetic core (50A) during an overmoulding.

3. Electrical connection assembly according to Claim 1, the magnetic core (50A, 50B) comprising a single ferromagnetic part (50A1) delimiting a single air gap (53) or comprising two ferromagnetic parts (50B1) facing one another delimiting two air gaps (53).

4. Electrical connection assembly according to one of Claims 1 to 3, comprising a plurality of electrical conductors (111, 112, 113) and a plurality of magnetic cores, each electrical conductor (111, 112, 113) extending in the internal space of a respective magnetic core.

5. Electrical connection assembly according to the preceding claim, comprising an overmoulding (60A, 60B) keeping the magnetic cores (50A, 50B) together.

6. Electrical connection assembly according to one of Claims 1 to 5, wherein the electrical conductor (111, 112, 113) has a parallelepipedal section and is centred on the centre of the ellipse and wherein the half great axis a and the half small axis b of the ellipse are such that

[Math 13]

$$a \geq \frac{f1}{2} + d1$$

in which f1 is the thickness of the electrical conductor (111, 112, 113) in the direction of the great axis a and d1 is a first margin between the periphery of the electrical conductor (111, 112, 113) and the inner edge of the magnetic core on the great axis a and b is such that the minimal distance between the periphery of the electrical conductor (111, 112, 113) and the inner edge of the magnetic core (50A, 50B), in a direction parallel to the small axis b, is greater than or equal to d2, d2 being a second margin between the periphery of the electrical conductor (111, 112, 113) and the inner edge (51A) of the magnetic core (50A, 50B).

7. Electrical connection assembly according to Claim 6, wherein

[Math 14]

$$a = \frac{f1}{2} + d1$$

**12**

and b is such that the minimal distance between the form and the inner edge (51A) of the magnetic core (50A, 50B) in a direction parallel to the small axis B is equal to d2.

8. Electrical connection assembly according to one of Claims 6 and 7, wherein 1 mm < d1 < 5 mm and/or 0.5 mm < d2 < 5 mm and/or, when Claim 6 depends on Claim 7, 0.5 mm < d3 < 5 mm.

9. Sensor assembly comprising an electrical connection assembly according to one of Claims 1 to 8 and a measurement sensor (40) comprising a sensitive element (44) extending in the at least one air gap (53) of the at least one magnetic core (50A, 50B), said sensitive element being configured so as to measure an intensity of the magnetic field induced by a current circulating in the at least one corresponding electrical conductor (111, 112, 113).

FIGURE 1

FIGURE 2

FIGURE 3

FIGURE 4

FIGURE 5

FIGURE 7

FIGURE 6

FIGURE 8

FIGURE 9

FIGURE 10

FIGURE 11

FIGURE 12

FIGURE 13

FIGURE 14

FIGURE 15

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- CN 201277993 Y
- WO 2010149331 A1
- JP 2006066718 A
- WO 2013161496 A1
- US 2006290454 A1